# EUROPÄISCHE PATENTSCHRIFT

(11) **EP 1 771 879 B1**
(45) Veröffentlichungstag und Bekanntmachung des Hinweises auf die Patenterteilung: **02.01.2019**
(21) Anmeldenummer: 05774258.7
(22) Anmeldetag: 25.07.2005
(51) Int. Cl.: H01L 23/29, H01L 31/0304, H01L 31/103, H01L 31/18

(54) **HALBLEITERBAUELEMENT MIT EINER PASSIVIERUNGSSCHICHT UND VERFAHREN ZU SEINER HERSTELLUNG**
SEMICONDUCTOR DEVICE WITH A PASSIVATION LAYER AND METHOD FOR PRODUCTION THEREOF
DISPOSITIF SEMI-CONDUCTEUR COMPRENANT UNE COUCHE DE PASSIVATION ET SON PROCÉDÉ DE FABRICATION

(30) Priorität: 30.07.2004 DE 102004037191
(43) Veröffentlichungstag der Anmeldung: 11.04.2007
(73) Patentinhaber: Fraunhofer-Gesellschaft zur Förderung der angewandten Forschung e.V., 80686 München (DE)
(72) Erfinder: FUCHS, Frank, 79211 Denzlingen (DE); REHM, Robert, 77955 Ettenheim (DE); WALTHER, Martin, 79232 March (DE)
(86) Internationale Anmeldenummer: PCT/EP2005/008075
(87) Internationale Veröffentlichungsnummer: WO 2006/013034

(56) Entgegenhaltungen:
- WO-A-2004/059038
- GB-A- 2 133 928
- US-A1- 2002 084 468
- US-A1- 2003 211 642
- PATENT ABSTRACTS OF JAPAN Bd. 2000, Nr. 01, 31. Januar 2000 (2000-01-31) & JP 11 274167 A (TOSHIBA CORP), 8. Oktober 1999 (1999-10-08)

## Beschreibung

Die Erfindung betrifft ein Halbleiterbauelement mit Passivierungsschicht und ein Verfahren zu dessen Herstellung. Unter Passivierung wird das Beschichten von planaren oder strukturierten Bauelementen verstanden, derart, dass die elektrischen Eigenschaften des Bauelements nicht von der umgebenden Atmosphäre abhängen.

Die Oberfläche eines Halbleiters stellt eine Störung des periodischen Gitters dar, die die elektrischen Eigenschaften des Halbleiters merklich verändern. Es kommt zur Bildung von Oberflächenzuständen, die durch chemisorption oder physisorption von Adsorbaten modifiziert werden können. Das Ergebnis ist eine Raumladungszone, deren Ausdehnung und Charakter die Eigenschaften der Oberfläche weitgehend bestimmen. Dies führt zu einer Beeinflussung der Lage des Ferminiveaus im aktiven Bereich des Bauelements und damit zu einer Abhängigkeit der elektrischen Eigenschaften von der umgebenden Atmosphäre, wie z.B. Luftfeuchtigkeit, und/oder Prozesschemie. Die Folge wechselnder Oberflächenzustände sind Oberflächenleckströme, die den Rauschpegels eines Halbleiterbauelements erhöhen. Die Leistungsfähigkeit aktiver Bauelemente, insbesondere solcher aus Materialien mit kleiner Bandlücke (z.B. Infrarot-Photodioden), hängt im wesentlichen von den Rauschbeiträgen ab. Daher ist eine wirksame Passivierung zur dauerhaften Unterdrückung insbesondere von Oberflächenleckströmen und zur Stabilisierung der elektrischen Eigenschaften der Bauelementoberfläche essentiell.

Bauelemente auf der Basis von Elementhalbleitern wie Silizium oder Germanium und der III-V-Halbleiter werden gemäß dem Stand der Technik durch das Aufbringen einer Schicht aus Isolatormaterial passiviert. Übliche Materialien dafür sind SiO₂, SiₓN_{y} oder SiOₓN_{y}. Diese werden mit verschiedenen Depositionsverfahren, z.B. Low Pressure Chemical Vapor Deposition (LPCVD), Plasma Enhanced Chemical Vapor Deposition (PECVD) oder Sputtern, aufgebracht.

Das Dokument US 2003/211642 A1 offenbart ein Halbleiterbauelement, welches GaAs enthält, mit den weiteren Merkmalen, dass es eine Mesa-Strukturierung aufweist und an mindestens einer Seitenfläche der Strukturierung zumindest teilweise eine oxidhaltige Passivierungsschicht aufgebracht ist.
Das Dokument JP 11 274167 A offenbart die Benutzung von AIGaAs zur Passivierung von GaAs.
Das Dokument GB-A-2 133 928 befasst sich mit der Passivierung von mesa-strukturierten Photodetektoren mittels AlAsSb or AlGaAsSb. InP oder InGaAsP wird als aktive Halbleiterschicht verwendet.

Halbleiterbauelemente mit kleiner Bandlücke, wie z.B. Quecksilber-Cadmium-Tellurid (MCT), können nach dem Stand der Technik durch ein Material mit größerer Bandlücke, z.B. CdTe, passiviert werden. Der Effekt der Passivierung beruht hierbei auf der Kombination des Halbleiters CdTe mit großer Bandlücke (E_{g} = 1.6 eV) mit dem Diodenmaterial des Bauelements mit kleinerer Bandlücke (E_{g} < 350 meV). Im Bereich der Diode kommt es zu einer Aufweitung der effektiven Bandlücke. Dies führt zu einer Verarmung der jeweiligen Minoritätsladungsträger im Randbereich der Diode und somit zu einer Verringerung der Oberflächenleckströme. Die Verfahren und Prozesse zur Herstellung sowie zur Bearbeitung von MCT sind aufwändig, fehleranfällig und kostenintensiv.

Nach dem Stand der Technik können Halbleiterbauelemente mit kleiner Bandlücke auch auf der Basis der Legierung AlₓGa_{y}In_{1-x-y}As_{z}Sb_{1-z} hergestellt werden. In Abhängigkeit der Parameter x, y und z kann eine Bandlücke von weniger als 350 meV eingestellt werden.

Insbesondere mittels Heterostrukturen und Übergittern zweier unterschiedlicher Legierungen, wie beispielsweise InAs und Ga₁₋ₓInₓSb Einzelschichten mit Dicken zwischen 2 nm und 10 nm, können Bauelemente mit kleinen Bandlücken hergestellt werden. Allerdings ist die Passivierung solcher Bauelemente bisher nicht auf einfache Weise möglich.

Der Erfindung liegt demnach die Aufgabe zugrunde, ein Verfahren zur Passivierung von AlₓGa_{y}In_{1-x-y}As_{z}Sb_{1-z}-haltigen Halbleiterbauelementen mit kleiner Bandlücke anzugeben.

Die Lösung der Aufgabe besteht in einem Halbleiterbauelement, welches AlxGayIn1-x-yAszSb1-z enthält, wobei die Parameter x, y und z derartig ausgewählt sind, dass sich eine Bandlücke von weniger als 350 meV einstellt, es eine Mesa-Strukturierung aufweist und an mindestens einer Seitenfläche der Strukturierung zumindest teilweise eine AlnGa1-nAsmSb1-m-haltige Passivierungsschicht aufgebracht ist, wobei der Parameter n aus dem Intervall von 0.4 bis 1 und der Parameter m aus dem Intervall von 0 bis 1 gewählt ist.

Weiterhin besteht die Lösung in einem Verfahren zur Herstellung eines Halbleiterbauelements, welches die folgenden Schritte umfasst:
Herstellung mindestens eines aktiven Halbleiterbereichs aus einem AlₓGa_{y}In_{1-x-y}As_{z}Sb_{1-z}-haltigen Material mit einer Bandlücke von weniger als 350 meV, Ausbilden von Mesa-Strukturen im aktiven Halbleiterbereich und Aufbringen einer AlₙGa₁₋ₙAsₘSb₁₋ₘ-haltigen Passivierungsschicht auf der Oberfläche des aktiven Halbleiterbereichs, wobei der Parameter n aus dem Intervall von 0.4 bis 1 und der Parameter m aus dem Intervall von 0 bis 1 gewählt ist.

Zwischen dem obersten noch voll besetzten Band (Valenzband) und dem darüber liegenden Leitungsband liegt ein Energiebereich, in dem nach der Quantenmechanik keine erlaubten elektronischen Zustände existieren. Dieser Bereich wird als Bandlücke bezeichnet. Halbleiterbauelemente mit unterschiedlichen Anwendungsbereichen erfordern unterschiedliche Bandlücken.

Die Herstellung des aktiven Halbleiterbereichs kann beispielsweise durch epitaktische Abscheidung auf GaSb-Substrate oder GaSb-Pufferschichten mit 001-Orientierung erfolgen. Dem Fachmann ist dabei geläufig, durch Variation der Parameter x, y und z bei der Herstellung des aktiven Halbleiterbereichs die Gitterkonstante und die Bandlücke nach der gewünschten Anwendung einzustellen. Um kleine und kleinste Bandlücken bis hinab zu 60 meV zu erzielen, wird der Fachmann insbesondere auch Übergitter in Betracht ziehen, welche beispielsweise aus InAs, GaSb, InSb, AlSb und deren Mischreihen bestehen. Insbesondere wird der Fachmann Übergitter aus InAs und Ga₁₋ₓInₓSb Einzelschichten mit Dicken zwischen 2 nm und 10 nm in Betracht ziehen.

Um eine Passivierungsschicht mit möglichst geringen Defekten, einer hohen Haftung und geringen mechanischen Spannungen aufwachsen zu können, ist es von Vorteil, wenn das Material der Passivierungsschicht in etwa die gleiche Gitterkonstante wie das Material des Halbleiterbauelements hat. Durch Variation des Parameters m kann der As-Gehalt in der AlₙGa₁₋ₙAsₘSb₁₋ₘ -Legierung eingestellt und deren Gitterkonstante angepasst werden. Der Fachmann wird den As-Gehalt selbstverständlich derart wählen, dass sich eine möglichst gute Anpassung an das Basismaterial ergibt. Insbesondere wird er dabei den Bereich von etwa 0 bis etwa 0.15 berücksichtigen.

Der Parameter n bezeichnet den Al-Gehalt in der Verbindung. Die passivierende Wirkung der erfindungsgemäßen Schicht stellt sich dann ein, wenn der Parameter n aus dem Intervall von etwa 0.4 bis 1 gewählt wird. Besonders bevorzugt ist ein Bereich von etwa 0.5 bis etwa 0.85. Bei einem zu geringen Al-Gehalt ist die Wirkung der Passivierungsschicht unzureichend. Eine Erhöhung des Al-Gehalts vergrößert die Bandlücke der AlₙGa₁₋ₙAsₘSb₁₋ₘ - Legierung und damit die passivierende Wirkung. Ein zu hoher Al-Anteil führt jedoch zu einer beschleunigten oxidationsbedingten Degeneration der Passivierungsschicht.

Eine weitere Optimierung der Passivierungsschicht ist durch eine gezielte p- oder n-Dotierung des Schichtmaterials möglich. Durch diese Maßnahme kann Einfluss auf das Ferminiveau an der Grenzfläche aktiver Bereich/Passivierungsschicht des Bauelements genommen werden. Beispielsweise können durch eine Dotierung mit Beryllium oder Tellur gezielt die Oberflächenleckströme beeinflusst werden. Der Fachmann wird selbstverständlich in Abhängigkeit des Anwendungsgebietes, des Halbleitermaterials und der Zusammensetzung der Passivierungsschicht die Art und Menge des Dotierstoffes wählen.

Besonders bevorzugt ist der Einsatz der erfindungsgemäßen Passivierungsschicht insbesondere bei bipolaren Photodioden mit einer Bandlücke zwischen etwa 60meV und etwa 300meV. Die Leistungsfähigkeit dieser Bauteile wird ganz wesentlich durch Oberflächenleckströme bestimmt. Durch die Passivierungsschicht lassen sich diese Oberflächenleckströme kontrollieren bzw. minimieren.

Obgleich die erfindungsgemäße Passivierungsschicht für planare und strukturierte Bauelemente gleichermaßen geeignet ist, eignet sie sich insbesondere für mesa-strukturierte Bauelemente. Mesa-Stukturen sind über die Waferoberfläche hinausragende Strukturen, in etwa in Form eines Tafelberges, mit einer plateauförmigen Abplattung auf der Oberseite und begrenzenden Seitenflächen.

Die Mesa-Strukturen können dabei rund oder eckig sein. Insbesondere können die Mesa-Strukturen auch eine quadratische Grundfläche haben. Besonders bevorzugt weisen die begrenzenden Seitenflächen eine Orientierung von etwa 45 Grad zu den natürlichen Spaltflächen des Kristalls auf. Damit sind die beiden Flanken einer Mesa-Struktur kristallographisch weitgehend äquivalent, werden beim Ätzprozess gleichartig geätzt und epitaktisch gleichartig überwachsen.

Da das Verhältnis von Volumen zu Oberfläche bei Mesa-Strukturen schlechter ist als bei planaren Bauelementen, haben die Oberflächenleckströme in diesem Fall einen besonders großen Einfluss und der Passivierung der Oberflächen kommt in diesem Fall eine besonders große Bedeutung zu.

Um die Passivierungsschicht vor Oxidation zu schützen, ist in einer weiteren Ausgestaltung der Erfindung auf der Passivierungsschicht zumindest teilweise eine Oxidationsschutzschicht aufgebracht. Für diese Schutzschicht eignen sich prinzipiell alle Materialien, welche für oxidierende Verbindungen undurchlässig sind und als Dünnschicht mit einer Dicke von etwa 10 nm bis etwa 2 µm abscheidbar sind. Durch die Oxidationsschutzschicht wird der Einfluss von beispielsweise Luftsauerstoff oder oxidierenden Verbindungen, welche zur Prozessierung des Bauelementes eingesetzt werden, auf die Passivierungsschicht unterbunden. Damit wird die Langzeitstabilität des Bauelementes wunschgemäß erhöht.

Bevorzugt enthält eine solche Oxidationsschutzschicht SiₚN_{q} und/oder SiO₂ und/oder SiOₚN_{q}, so dass sich eine hochohmige Schicht bildet, welche selbst weitgehend chemisch inert ist.

Dem Fachmann ist dabei geläufig, dass beispielsweise zur Kontaktierung vorgesehene Flächenbereiche in einfacher Weise mit einem Kontakt aus einem Metall oder einer Legierung versehen werden können, wenn diese Stellen von der Passivierungs- und/oder Oxidationsschutzschicht ausgenommen werden. Dies kann durch Maskierung bei der Herstellung oder durch nachträgliches Entfernen der Passivierungs- und/oder Oxidationsschutzschicht in vorbestimmten Flächenbereichen geschehen. Zur Entfernung eignet sich insbesondere ein Ätzverfahren. Vorteilhaft kann dabei zur Entfernung der Passivierungsschicht die Oxidationsschutzschicht auch als Ätzmaske verwendet werden.

Als Verfahren zur Herstellung des aktiven Halbleiterbereichs und der Passivierungsschicht eignet sich die Epitaxie, insbesondere die Molekularstrahlepitaxie. Damit ist die Abscheidung von gitterangepassten, einkristallinen Schichten möglich. Durch entsprechende Prozessführung kann die Zusammensetzung der Schichten in weiten Bereichen beeinflusst werden.

Nach einer ersten Alternative des Herstellungsverfahrens kann die Passivierungsschicht unmittelbar nach der aktiven Halbleiterschicht aufgebracht werden, ohne den Wafer aus dem Vakuum der Abscheidungsanlage auszuschleusen.

In einer zweiten Alternative ist es aber auch möglich, nach der Abscheidung der aktiven Halbleiterschicht diese z.B. in einem konventionellen Photolithographieverfahren zu strukturieren. In diesem Fall werden Rückstände des Lithographieprozesses nass- und/oder trockenchemisch entfernt.

Bevorzugt wird die Oberfläche des aktiven Halbleiterbereichs nach dem Ätzen durch thermische Desorption im Vakuum gereinigt. Dadurch werden auf den Oberflächen befindliche Adsorbate und Oxidschichten entfernt und die Waferoberfläche für den nächsten Prozessschritt vorbereitet. Die Haftung der Passivierungsschicht wird auf einer so gereinigten Oberfläche besonders gut. Darüber hinaus wird das Ferminiveau des Bauelementes nicht durch Oxide beeinflusst. Die Oxid-Desorption erfolgt insbesondere bei Temperaturen zwischen etwa 500°C und etwa 620°C.

In einer bevorzugten Ausgestaltung des Verfahrens wird eine Verringerung des Sb-Gehalts der aktiven Halbleiterschicht durch Desorption von deren Oberfläche vermieden, indem das Bauelement während der thermischen Oxid-Desorption dem Molekularstrahl einer Effusionszelle ausgesetzt wird. Somit wird der Desorption der Gruppe-V-Atome der AlₓGa_{y}In_{1-x-y}As_{z}Sb_{1-z}-Schicht des Bauelementes entgegengewirkt. Sofern der Sb-Molekularstrahl unter nicht-senkrechten Einfallsrichtungen zugeführt wird, sind mesa-strukturierte Bereiche je nach Stellung des Wafers und der geometrischen Anordnung einer Teilabschattung ausgesetzt. Daher ist es vorteilhaft, den Wafer zu rotieren. Auf den so vorbehandelten Wafer werden die AlₙGa₁₋ₙAsₘSb₁₋ₘ-haltige Passivierungsschicht und gegebenenfalls die Oxidationsschutzschicht aufgebracht.

Nachfolgend soll die Erfindung anhand eines Ausführungsbeispiels und mehrerer Figuren näher erläutert werden.

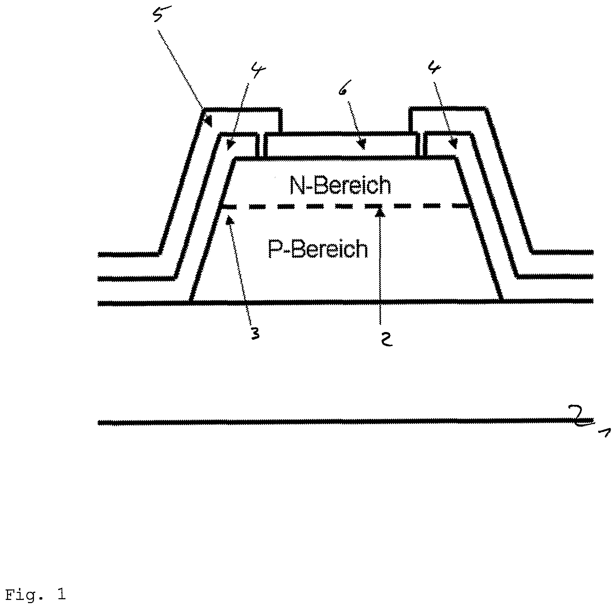

Fig. 1 zeigt eine schematische Darstellung der Schichtfolge eines mesa-strukturierten Bauelements.

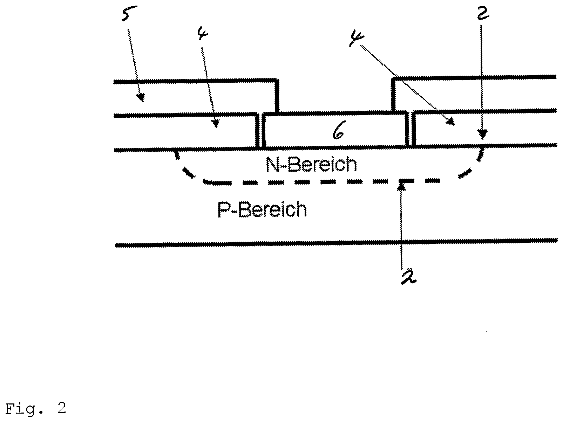

Fig. 2 zeigt eine schematische Darstellung der Schichtfolge eines planar prozessierten Bauelements.
Fig. 3 zeigt eine grafische Darstellung zur Abhängkeit der Oberflächenleckströme einer Infrarot-Fotodiode von der Qualität der AlₙGa₁₋ₙAsₘSb₁₋ₘ-Passivierungsschicht.
Fig. 4 zeigt eine grafische Darstellung zur Abhängigkeit der Oberflächenleckströme von der Dotierung der AlₙGa₁₋ₙAsₘSb₁₋ₘ-Passivierungsschicht.

Beispielhaft soll die Herstellung einer Infrarot-Photodiode beschrieben werden.

In einem ersten Prozessschritt wird die Detektorstruktur mit einem p-n-Übergang (2) mit dem Verfahren der Molekularstrahlepitaxie (MBE) ganzflächig auf einem GaSb-Substrat (1) mit (001)-Orientierung abgeschieden.

Mit einem konventionellen Lithographieverfahren wird nachfolgend eine strukturierte Photolack-Maske auf der Waferoberfläche erzeugt. Die Orientierung der rechteckigen Mesas (3) erfolgt in (100)- bzw. (010)-Richtung und somit unter 45 Grad zu den natürlichen Spaltflächen des Kristalls. Die Übertragung der Lackstruktur in den Halbleiter erfolgt mittels nass- oder trockenchemischer Ätzverfahren.

Anschließend werden die Photolackmaske sowie eventuell vorhandene Ätzrückstände in mehreren Prozessschritten entfernt. Diese schließen folgende Reinigungs- und Ätzschritte ein:
- Spülen mit Lösemittel (Aceton, Isopropanol)
- Behandlung mit wässriger NH₄F-Lösung und Spülung mit deionisiertem Wasser (DI-Wasser)
- HCl-Reinigung mit DI-Wasserspülung
- Sauerstoff-Plasmabehandlung
- Zitronensäureätzung mit DI-Wasserspülung
- HCl-Reinigung mit DI-Wasserspülung.

Nach vollständiger Entfernung der Lackmaske und der Ätzrückstände wird der mesa-strukturierte Wafer wieder in die Molekularstrahlepitaxieanlage eingeschleust. Nach Ausheizen des Wafers zur Entfernung von Adsorbaten (Wasser) auf der Oberfläche werden die Oxidschichten auf den Mesas und auf den Seitenflanken thermisch desorbiert. Diese Oxid-Desorption findet bei Antimon-Stabilisierung statt. Um Abschattungseffekte zu vermeiden, rotiert der Wafer in diesem Verfahrensschritt. Die Desorption des Oxids beginnt in etwa bei einer Temperatur von 500°C. Die Temperatur des Wafers wird langsam bis auf 540°C erhöht. Die Temperatur wird dabei mit einem Pyrometer bestimmt. Bei dieser Temperatur verbleibt der Wafer 5 Minuten unter der bereits erwähnten Antimon-Stabilisierung, um die auf den Oberflächen befindlichen Oxidschichten möglichst vollständig zu desorbieren.

Anschließend wird bei 530°C etwa 5 Minuten lang eine Al_{0.5}Ga_{0.5}As_{0.93}Sb_{0.07}-Passivierungsschicht (4) mit einer Dicke von etwa 150 nm epitaktisch aufgewachsen.

Um die Al_{0.5}Ga_{0.5}As_{0.93}Sb_{0.07}-Schicht vor Oxidation zu schützen, wird der Wafer nach dem Überwachsen der Passivierungsschicht (4) aus der MBE-Anlage ausgeschleust und eine 200 nm dicke Siliziumnitridschicht (5) als Oxidationsschutzschicht aufgebracht.

Die Siliziumnitridschicht wird als Ätzmaske verwendet, um die Kontaktbereiche freizulegen. Das Entfernen der Al_{0.5}Ga_{0.5}As_{0.93}Sb_{0.07}-Schicht in den für die Kontaktierung vorgesehenen Bereichen erfolgt mit einem nasschemischen Ätzverfahren unter Verwendung von HCl und H₂O₂ in alkoholischer Lösung sowie anschließender Spülung mit deionisiertem Wasser. Danach wird ein metallischer Kontakt (6) auf die vorbereitete Oberfläche aufgebracht.

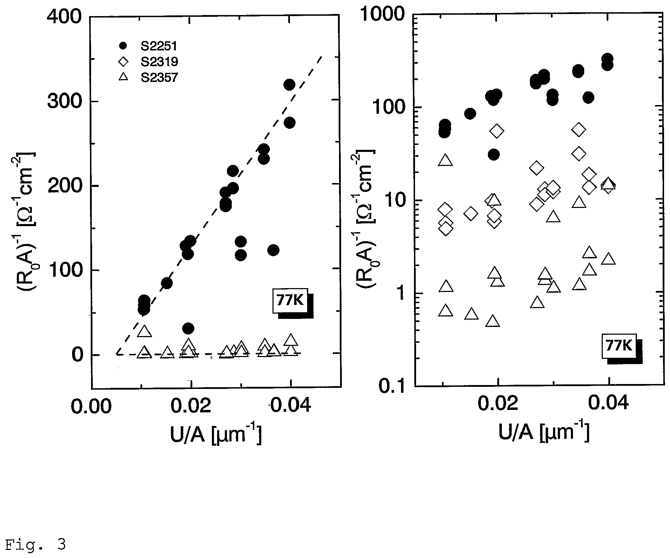

Wie die Fig. 3 zeigt, hat die Qualität der Passivierungsschicht unmittelbaren Einfluss auf die Oberflächenleckströme. Als Maß für den Leckstrom ist das Inverse des differenziellen Widerstands (R₀A)⁻¹ für verschiedene Geometrien über dem Verhältnis von Umfang zu Fläche (U/A) aufgetragen. Dabei bezeichnet R0 die Ableitung der Strom-Spannungskennlinie dU/dI des Bauelementes bei U = 0V. Umfang und Fläche werden an der Ortsposition des p-n-Übergangs bestimmt. Der lineare Anstieg von (R₀A)⁻¹ mit zunehmendem U/A-Verhältnis (Kreise) ist auf die auftretenden Oberflächenleckströme zurückzuführen. Mit einer erfindungsgemäßen AlₙGa₁₋ₙAsₘSb₁₋ₘ-Passivierungsschicht lassen sich diese Leckströme um mehr als einen Faktor 1000 reduzieren, so dass sie messtechnisch nicht mehr erfasst werden können. Die Leckströme sind dann unabhängig vom Verhältnis U/A (Dreiecke).

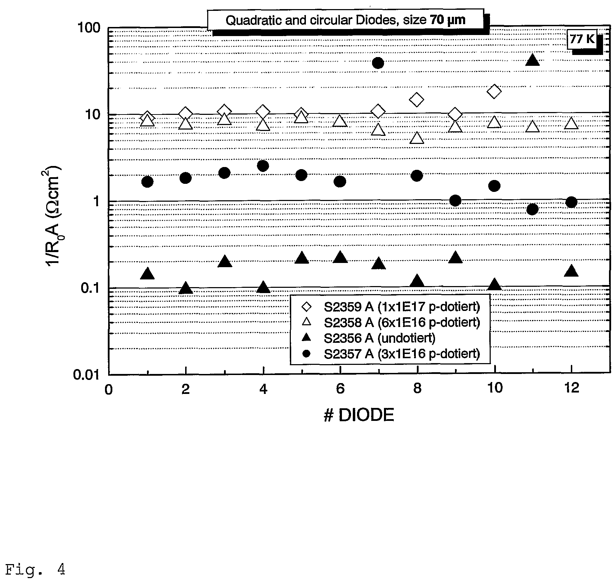

Die Oberflächenleckströme werden durch die Lage des Ferminiveaus im Bereich des p-n-Überganges beeinflusst. Da die Position des Ferminiveaus durch zusätzliche Dotierung der Passivierungsschicht beeinflusst werden kann, kann durch Dotierung der Passivierungsschicht auch der Oberflächenleckstrom beeinflusst werden. Fig. 4 zeigt das Inverse des differenziellen Widerstands (R₀A)⁻¹ als Maß für den Leckstrom für verschiedene Infrarot-Photodioden mit unterschiedlicher Dotierung der Passivierungsschicht. Beispielhaft ist hier eine unerwünschte Erhöhung der Leckströme durch zunehmende Beryllium-Dotierung gezeigt. Selbstverständlich wird der Fachmann in Abhängigkeit des Bauelementes und der genauen Zusammensetzung der Passivierungsschicht einen optimalen Dotierstoff und dessen Konzentration suchen, um die Oberflächenleckströme weiter zu reduzieren.

## Patentansprüche

1. Halbleiterbauelement, welches eine Mesa-Strukturierung (3) aufweist, **dadurch gekennzeichnet, dass** es AlₓGa_{y}In_{1-x-y}As_{z}Sb_{1-z} enthält, wobei die Parameter x,y und z derartig ausgewählt sind, dass sich eine Bandlücke von weniger als 350 meV einstellt, und an mindestens einer Seitenfläche der Strukturierung (3) zumindest teilweise eine AlₙGa₁₋ₙAsₘSb₁₋ₘ-haltige Passivierungsschicht (4) aufgebracht ist, wobei der Parameter n aus dem Intervall von 0.4 bis 1 und der Parameter m aus dem Intervall von 0 bis 1 gewählt ist.

2. Halbleiterbauelement nach Anspruch 1, **dadurch gekennzeichnet, dass** der aktive Bereich InAs- und Ga_{y}In_{1-y}Sb-haltige Einzelschichten mit Schichtdicken von etwa 2 nm bis etwa 10 nm enthält.

3. Halbleiterbauelement nach Anspruch 1 oder 2, **dadurch gekennzeichnet, dass** der Parameter m aus dem Intervall von 0 bis 0.15 gewählt ist.

4. Halbleiterbauelement nach Anspruch 3, **dadurch gekennzeichnet, dass** der Parameter m gleich 0.07 beträgt.

5. Halbleiterbauelement nach einem der Ansprüche 1 bis 4, **dadurch gekennzeichnet, dass** der Parameter n aus dem Intervall von 0.5 bis 0.85 gewählt ist.

6. Halbleiterbauelement nach einem der Ansprüche 1 bis 5, **dadurch gekennzeichnet, dass** die Passivierungsschicht (4) eine p- oder n-Dotierung aufweist.

7. Halbleiterbauelement nach Anspruch 6, **dadurch gekennzeichnet, dass** die Passivierungsschicht (4) mit Beryllium oder Tellur dotiert ist.

8. Halbleiterbauelement nach einem der Ansprüche 1 bis 7, **dadurch gekennzeichnet, dass** es ein bipolares Halbleiterbauelement umfasst.

9. Halbleiterbauelement nach Anspruch 8, **dadurch gekennzeichnet, dass** es eine bipolare Photodiode umfasst.

10. Halbleiterbauelement nach einem der Ansprüche 1 bis 9, **dadurch gekennzeichnet, dass** auf der Passivierungsschicht (4) zumindest teilweise eine Oxidationsschutzschicht (5) aufgebracht ist.

11. Halbleiterbauelement nach Anspruch 10, **dadurch gekennzeichnet, dass** die Oxidationsschutzschicht (5) SiₚN_{q} und/oder SiO₂ und/oder SiOₚN_{q} enthält.

12. Halbleiterbauelement nach einem der Ansprüche 1 bis 11, **dadurch gekennzeichnet, dass** mindestens eine Seitenfläche der Mesa-Strukturen (3) in (010)-, (0-10)-, (100)- oder (-100)-Orientierung vorliegt.

13. Halbleiterbauelement nach einem der Ansprüche 1 bis 12, **dadurch gekennzeichnet, dass** an von der Passivierungsschicht (4) nicht bedeckten Flächenbereichen ein Metallkontakt (6) vorgesehen ist.

14. Verfahren zur Herstellung eines Halbleiterbauelementes, welches die folgenden Schritte umfasst:
• Herstellen mindestens eines aktiven Halbleiterbereiches aus einem AlₓGa_{y}In_{1-x-y}As_{z}Sb_{1-z}-haltigem Material mit einer Bandlücke von weniger als 350 meV
• Ausbilden von : Mesa-Strukturen (3) im aktiven Halbleiterbereich
• Aufbringen einer AlₙGa₁₋ₙAsₘSb₁₋ₘ-haltigen Passivierungsschicht (4) auf mindestens einer Seitenfläche der Mesa-Strukturen (3) wobei der Parameter n aus dem Intervall von 0.4 bis 1 und der Parameter m aus dem Intervall von 0 bis 1 gewählt ist

15. Verfahren nach Anspruch 14, **dadurch gekennzeichnet, dass** der aktive Halbleiterbereich aus mindestens einer einer InAs-haltigen Schicht mit einer Dicke von etwa 2 nm nis etwa 10 nm hergestellt wird, auf welche mindestens eine Ga_{y}In_{1-y}Sb-haltige Schicht mit einer Dicken von etwa 2 nm bis etwa 10 nm aufgebracht wird.

16. Verfahren nach einem der Ansprüche 14 oder 15, **dadurch gekennzeichnet, dass** der Parameter m aus dem Intervall von 0 bis 0.15 ausgewählt wird.

17. Verfahren nach einem der Ansprüche 14 bis 16, **dadurch gekennzeichnet, dass** der Parameter n aus dem Intervall von 0.5 bis 0.85 ausgewählt wird.

18. Verfahren nach einem der Ansprüche 14 bis 17, **dadurch gekennzeichnet, dass** der Passivierungsschicht (4) ein Dotierstoff zugefügt wird.

19. Verfahren nach einem der Ansprüche 14 bis 18, **dadurch gekennzeichnet, dass** auf der dem aktiven Halbleiterbereich abgewandten Seite der Passivierungsschicht (4) eine Oxidationsschutzschicht (5) aufgebracht wird.

20. Verfahren nach einem der Ansprüche 14 bis 19, **dadurch gekennzeichnet, dass** der aktive Halbleiterbereich und/oder die Passivierungsschicht (4) mittels Molekularstrahlepitaxie hergestellt wird.

21. Verfahren nach einem der Ansprüche 14 bis 20, **dadurch gekennzeichnet, dass** die Strukturierung durch Photolithographie erfolgt.

22. Verfahren nach einem der Ansprüche 14 bis 21, **dadurch gekennzeichnet, dass** vor der Herstellung der Passivierungsschicht (4) die Oberfläche des aktiven Halbleiterbereiches durch thermische Desorption gereinigt wird.

23. Verfahren nach Anspruch 22, **dadurch gekennzeichnet, dass** die thermische Desorption bei einer Temperatur von etwa 500°C bis etwa 620°C erfolgt.

24. Verfahren nach einem der Ansprüche 22 oder 23, **dadurch gekennzeichnet, dass** die thermische Desorption bei gleichzeitiger Antimonstabilisierung vorgenommen wird.

25. Verfahren nach einem der Ansprüche 14 bis 24, **dadurch gekennzeichnet, dass** das Halbleiterbauelement ein Infrarot-Photodioden-Array umfasst.

## Claims

1. Semiconductor device having mesa structuring (3), **characterized in that** it contains AlₓGa_{y}In_{1-x-y}As_{z}Sb_{1-z}, wherein the parameters x, y and z are selected in such a manner that a band gap of less than 350 meV is established, and a passivation layer (4) containing AlₙGa₁₋ₙAsₘSb₁₋ₘ is at least partially applied to at least one side surface of the structuring (3), wherein the parameter n is selected from the range of 0.4 to 1 and the parameter m is selected from the range of 0 to 1.

2. Semiconductor device according to Claim 1, **characterized in that** the active area contains individual layers which contain InAs and Ga_{y}In_{1-y}Sb and have layer thicknesses of approximately 2 nm to approximately 10 nm.

3. Semiconductor device according to Claim 1 or 2, **characterized in that** the parameter m is selected from the range of 0 to 0.15.

4. Semiconductor device according to Claim 3, **characterized in that** the parameter m is equal to 0.07.

5. Semiconductor device according to one of Claims 1 to 4, **characterized in that** the parameter n is selected from the range of 0.5 to 0.85.

6. Semiconductor device according to one of Claims 1 to 5, **characterized in that** the passivation layer (4) has p-type or n-type doping.

7. Semiconductor device according to Claim 6, **characterized in that** the passivation layer (4) is doped with beryllium or tellurium.

8. Semiconductor device according to one of Claims 1 to 7, **characterized in that** it comprises a bipolar semiconductor device.

9. Semiconductor device according to Claim 8, **characterized in that** it comprises a bipolar photodiode.

10. Semiconductor device according to one of Claims 1 to 9, **characterized in that** an oxidation protection layer (5) is at least partially applied to the passivation layer (4).

11. Semiconductor device according to Claim 10, **characterized in that** the oxidation protection layer (5) contains SiₚN_{q} and/or SiO₂ and/or SiOₚN_{q}.

12. Semiconductor device according to one of Claims 1 to 11, **characterized in that** at least one side surface of the mesa structures (3) is present in a (010), (0-10), (100) or (-100) orientation.

13. Semiconductor device according to one of Claims 1 to 12, **characterized in that** a metal contact (6) is provided in surface areas not covered by the passivation layer (4).

14. Method for producing a semiconductor device, comprising the following steps of:
• producing at least one active semiconductor area from a material which contains AlₓGa_{y}In_{1-x-y}As_{z}Sb_{1-z} and has a band gap of less than 350 meV,
• forming mesa structures (3) in the active semiconductor area,
• applying a passivation layer (4) containing AlₙGa₁₋ₙAsₘSb₁₋ₘ to at least one side surface of the mesa structures (3), wherein the parameter n is selected from the range of 0.4 to 1 and the parameter m is selected from the range of 0 to 1.

15. Method according to Claim 14, **characterized in that** the active semiconductor area is produced from at least one layer which contains InAs and has a thickness of approximately 2 nm to approximately 10 nm, to which at least one layer which contains Ga_{y}In_{1-y}Sb and has a thickness of approximately 2 nm to approximately 10 nm is applied.

16. Method according to either of Claims 14 and 15, **characterized in that** the parameter m is selected from the range of 0 to 0.15.

17. Method according to one of Claims 14 to 16, **characterized in that** the parameter n is selected from the range of 0.5 to 0.85.

18. Method according to one of Claims 14 to 17, **characterized in that** a dopant is added to the passivation layer (4).

19. Method according to one of Claims 14 to 18, **characterized in that** an oxidation protection layer (5) is applied to that side of the passivation layer (4) which faces away from the active semiconductor area.

20. Method according to one of Claims 14 to 19, **characterized in that** the active semiconductor area and/or the passivation layer (4) is/are produced by means of molecular beam epitaxy.

21. Method according to one of Claims 14 to 20, **characterized in that** the structuring is carried out by means of photolithography.

22. Method according to one of Claims 14 to 21, **characterized in that,** before producing the passivation layer (4), the surface of the active semiconductor area is cleaned by means of thermal desorption.

23. Method according to Claim 22, **characterized in that** the thermal desorption is carried out at a temperature of approximately 500°C to approximately 620°C.

24. Method according to either of Claims 22 and 23, **characterized in that** the thermal desorption is carried out with simultaneous antimony stabilization.

25. Method according to one of Claims 14 to 24, **characterized in that** the semiconductor device comprises an infrared photodiode array.

## Revendications

1. Composant semiconducteur, lequel possède une structuration mésa (3), **caractérisé en ce qu'**il contient de l'AlₓGa_{y}In_{1-x-y}AS_{z}Sb_{1-z}, les paramètres x, y et z étant choisis de telle sorte qu'il s'établit un écart énergétique inférieur à 350 meV, et une couche de passivation (4) contenant de l'AlₙGa₁₋ₙAsₘSb₁₋ₘ étant appliquée au moins partiellement sur au moins une surface latérale de la structuration (3), le paramètre n étant choisi dans l'intervalle de 0,4 à 1 et le paramètre m étant choisi dans l'intervalle de 0 à 1.

2. Composant semiconducteur selon la revendication 1, **caractérisé en ce que** la zone active contient des couches individuelles contenant de de l'InAs et du Ga_{y}In_{1-y}Sb avec des épaisseurs de couche d'environ 2 nm à environ 10 nm.

3. Composant semiconducteur selon la revendication 1 ou 2, **caractérisé en ce que** le paramètre m est choisi dans l'intervalle de 0 à 0,15.

4. Composant semiconducteur selon la revendication 3, **caractérisé en ce que** le paramètre m est égal à 0,07.

5. Composant semiconducteur selon l'une des revendications 1 à 4, **caractérisé en ce que** le paramètre n est choisi dans l'intervalle de 0,5 à 0,85.

6. Composant semiconducteur selon l'une des revendications 1 à 5, **caractérisé en ce que** la couche de passivation (4) possède un dopage P ou N.

7. Composant semiconducteur selon la revendication 6, **caractérisé en ce que** la couche de passivation (4) est dopée avec du béryllium ou du tellure.

8. Composant semiconducteur selon l'une des revendications 1 à 7, **caractérisé en ce qu'**il comprend un composant semiconducteur bipolaire.

9. Composant semiconducteur selon la revendication 8, **caractérisé en ce qu'**il comprend une photodiode bipolaire.

10. Composant semiconducteur selon l'une des revendications 1 à 9, **caractérisé en ce qu'**une couche de protection anti-oxydation (5) est appliquée au moins partiellement sur la couche de passivation (4).

11. Composant semiconducteur selon la revendication 10, **caractérisé en ce que** la couche de protection anti-oxydation (5) contient du SiₚN_{q} et/ou du SiO₂ et/ou du SiOₚN_{q}.

12. Composant semiconducteur selon l'une des revendications 1 à 11, **caractérisé en ce qu'**au moins une surface latérale des structures mésa (3) se présente dans une orientation (010), (0-10), (100) ou (-100).

13. Composant semiconducteur selon l'une des revendications 1 à 12, **caractérisé en ce qu'**un contact métallique (6) se trouve au niveau des zones de surface non recouvertes par la couche de passivation (4).

14. Procédé de fabrication d'un composant semiconducteur, lequel comprend les étapes suivantes :
- fabrication d'au moins une zone semiconductrice active à partir d'un matériau contenant de l'AlₓGa_{y}In_{1-x-y}AS_{z}Sb_{1-z} ayant un écart énergétique inférieur à 350 meV
- formation de structures mésa (3) dans la zone semiconductrice active,
- application d'une couche de passivation (4) contenant de l'AlₙGa₁₋ₙAsₘSb₁₋ₘ sur au moins une surface latérale des structures mésa (3), le paramètre n étant choisi dans l'intervalle de 0,4 à 1 et le paramètre m étant choisi dans l'intervalle de 0 à 1.

15. Procédé selon la revendication 14, **caractérisé en ce que** la zone semiconductrice active est fabriquée à partir d'au moins une couche contenant de l'InAs ayant une épaisseur d'environ 2 nm à environ 10 nm, sur laquelle est appliquée au moins une couche de Ga_{y}In_{1-y}Sb ayant une épaisseur couche d'environ 2 nm à environ 10 nm.

16. Procédé selon l'une des revendications 14 ou 15, **caractérisé en ce que** le paramètre m est choisi dans l'intervalle de 0 à 0,15.

17. Procédé selon l'une des revendications 14 à 16, **caractérisé en ce que** le paramètre n est choisi dans l'intervalle de 0,5 à 0,85.

18. Procédé selon l'une des revendications 14 à 17, **caractérisé en ce qu'**un matériau de dopage est ajouté à la couche de passivation (4).

19. Procédé selon l'une des revendications 14 à 18, **caractérisé en ce qu'**une couche de protection anti-oxydation (5) est appliquée sur le côté de la couche de passivation (4) à l'opposé de la zone semiconductrice active.

20. Procédé selon l'une des revendications 14 à 19, **caractérisé en ce que** la zone semiconductrice active et/ou la couche de passivation (4) sont fabriquées au moyen de l'épitaxie par jet moléculaire.

21. Procédé selon l'une des revendications 14 à 20, **caractérisé en ce que** la structuration est effectuée par photolithographie.

22. Procédé selon l'une des revendications 14 à 21, **caractérisé en ce qu'**avant la fabrication de la couche de passivation (4), la surface de la zone semiconductrice active est nettoyée par désorption thermique.

23. Procédé selon la revendication 22, **caractérisé en ce que** la désorption thermique est effectuée à une température d'environ 500 °C à environ 620 °C.

24. Procédé selon l'une des revendications 22 ou 23, **caractérisé en ce que** la désorption thermique est réalisée simultanément avec une stabilisation à l'antimoine.

25. Procédé selon l'une des revendications 14 à 24, **caractérisé en ce que** le composant semiconducteur comprend un réseau de photodiodes à infrarouge.
